# EUROPEAN PATENT APPLICATION

(11) **EP 2 302 405 A2**
(43) Date of publication of application: **30.03.2011**
(21) Application number: 10460038.2
(22) Date of filing: 14.09.2010
(51) Int. Cl.: G01R 31/36

(54) **A system for measuring resistance of battery circuits**

(30) Priority: 28.09.2009 PL 38913309
(71) Applicant: Merawex spolka z ograniczona odpowiedzialnoscia, 44-122 Gliwice (PL)
(72) Inventor: Klimasara, Zdzislaw, 44-217 Rybnik (PL); Kowalczyk, Tomasz, 41-608 Swietochlowice (PL)
(74) Representative: Maslowski, Andrzej

(57) **Abstract**

A system for measuring the resistance of battery circuits, particularly banks of batteries arranged in parallel connections in automatic fire detection and protection devices is the object of the invention.

In the system according to the invention each measured circuit has the current transformer **PP** with a load in the form of the resistor **Ro** connected in series and the parallel resonant circuit **RLC,** and the measuring signals taken from these loads are routed through the amplifiers **Kz,** whereas the voltage measuring signal is additionally passed through the amplifier **KUz,** and the outputs of both of these amplifiers are fitted with the phase-sensitive detectors **DET** controlled by the clock signal **CLK,** which is switched by a microprocessor system to step-change its phase by 90° between measurements.

## Description

A system for measuring the resistance of battery circuits, particularly banks of batteries arranged in parallel connections in automatic fire detection and protection devices is the object of the invention.

There are known systems for measuring resistance which use direct current methods based on battery load characteristics determined beforehand. These methods are characterized by low measurement accuracy and sensitivity to battery operating conditions, that is temperature and load, and degree of wear.

Moreover, measuring resistance of a single branch in systems of batteries connected in parallel is not possible with these methods.

There are known systems for measuring resistance by means of alternating current using complex amplifying circuitries for measuring current and voltage. Application of these methods is challenged by the direct current of the operating battery - that is the load current or charge current - and the battery voltage, because both current and voltage may attain considerable values. Another problem encountered when applying these methods, particularly in the case of batteries of high capacity, is the impedance of connections resulting from the inductance of conductors, fuses, breakers, etc., the value of which is a substantial or the biggest contribution to the measured resistance of the whole circuit.

The present invention provides a system for measuring the resistance of a battery circuit, particularly a bank of batteries arranged in parallel connections which is characterized by ability to measure currents in individual branches connected in parallel, while exciting the entire bank of batteries with an alternating current. In each of the branches of the system disclosed the string of batteries is accompanied by resistances and inductances of the connections, including the resistances of protective devices. As the purpose of the measuring system is to determine the resistances of the entire branches, the resistances and inductances of only the batteries are treated as components of the resistances and inductances of connections. In each branch that includes a string of batteries there is a current transformer operating in a closed feedback loop, making use of the Hall effect and compensating magnetic flux. All these branches are connected in parallel one to another. The load connected to the current output of each transformer includes a resistor connected in series with a parallel resonant circuit. The direct current measuring signal taken from this resistor is amplified by an amplifier. The alternating current measuring signal taken from the resonant circuit is amplified by another amplifier which is AC coupled with that circuit via a coupling capacitor. A phase-sensitive detector controlled by an external clock signal is located at the output of the latter amplifier. The alternating voltage, common to all branches connected in parallel, reaches the voltage measurement circuitry where it is amplified by an amplifier which is AC coupled via a coupling capacitor with an input measuring signal. At the output of this amplifier there is a phase-sensitive detector controlled by the same clock signal as used for controlling the phase-sensitive detectors in the current measurement paths. The arrangement of branches connected in parallel is excited by a power amplifier generating sine wave current., The said amplifier is AC coupled with the excited system via a coupling capacitor. All measuring signals, that is the signals of alternating voltage, alternating currents and direct currents, are fed to the inputs of analog to digital converters of a microprocessor control system. This same control system generates: 1) a pulse width modulated signal which is then transformed by the power amplifier into a sine current signal, and 2) a clock signal to control the phase-sensitive detectors. The clock signal in the form of a square waveform with the pulse duty ratio of 0.5 is synchronous with the sine modulating the signal for the power amplifier. Proper operation of the system requires that the phase shift between the clock signal and the modulating sine is arbitrary but kept constant with an option to step-change this shift by 90° back and forth.

In the system according to the invention, the load of the transformer is divided into two parts, one of which, of direct current nature, is in the form of an appropriately sized resistor, whereas the second one, of alternating current nature with increased dynamic resistance, is in the form of a parallel resonant circuit. Such a design enables measurement of relatively small alternating currents superposed on a substantially larger direct current. Increased sensitivity of the alternating current measurement is the effect of higher dynamic resistance of the resonant circuit as compared to the resistance of the direct current load. In addition, the possibility of simultaneous measurement of direct currents in each of connected in parallel branchs enables to assess the condition of the battery bank by indication how uniformly the total current is distribution over the individual strings.

To measure the alternating voltage common to all branches connected in parallel and to measure the alternating current in each individual branch, the measuring system according to the invention makes use of phase-sensitive detection. This enables to isolate the (ohmic) resistance from the remaining passive components of the circuit for each branch of the battery bank separately. Moreover, the method applied here automatically takes account of frequency spectra, both amplitude and phase, of all components of the measuring paths, primarily of transformers and amplifiers, and of the generator exciting the system with an alternating current.

The described resistance measurement method enables meeting the requirements imposed on automatic fire detection and protection devices with respect to monitoring the resistance of battery circuits.

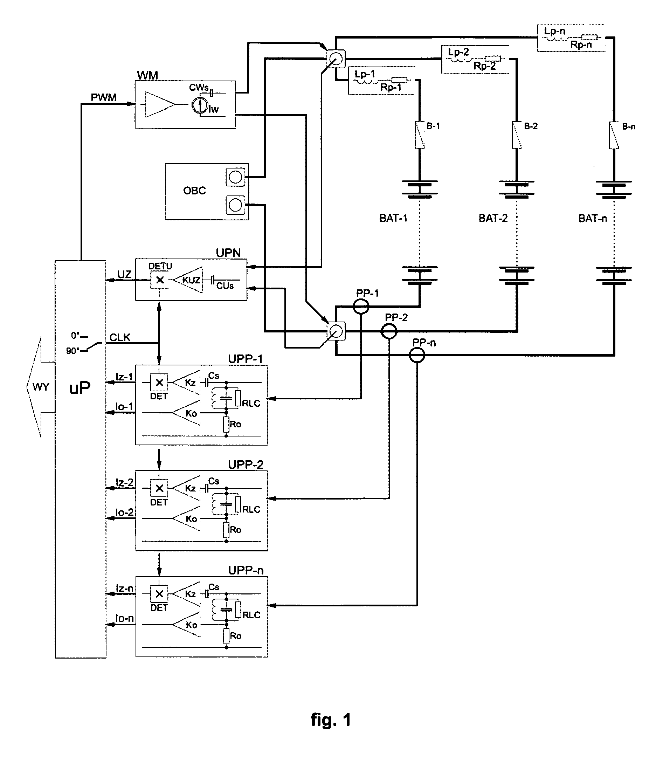

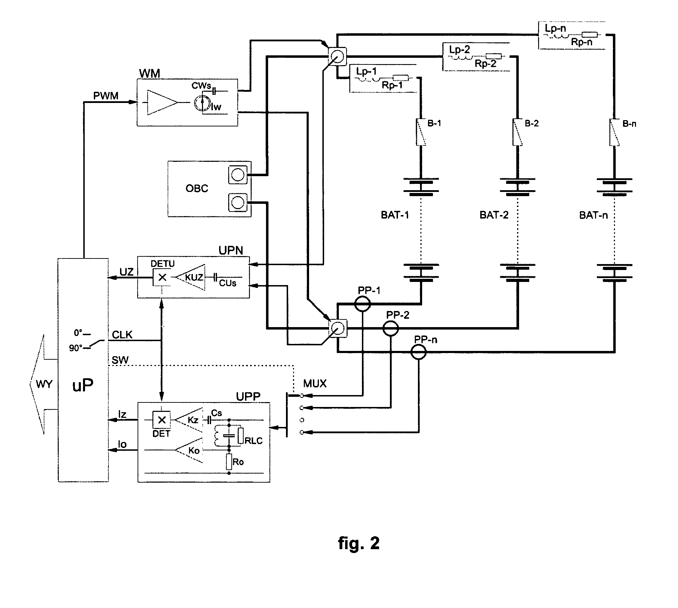

Exemplary embodiments of the invention are shown in drawings, wherein Fig. 1 represents the schematic diagram of the system for measuring the resistance of battery circuits connected in parallel, and Fig. 2 shows the schematic diagram of the system embodiment with an additional MUX switch and a single circuitry for current measurement.

As shown in Fig. 1, each of the branches, in addition to the string of batteries BAT-1 to BAT-n, has connection resistances Rp-1 to Rp-2, inclusive of resistances of protection devices B-1 to B-n, and connection inductances Lp-1 to Lp-n, inclusive of inductances of protection devices. As the purpose of the measuring system is the determination of the resistances of the entire branches, the resistances and inductances of the batteries themselves may be treated as components of the resistance and inductance of the connections. In every branch with a string of batteries BAT-1 to BAT-n there is a Hall effect current transformer PP-1 to PP-n, operating in a closed feedback loop. The signal from each of the transformers is fed to the appropriate current measuring circuitry UPP-1 to UPP-n. Each current measuring circuitry UPP includes the resistor Ro connected in series with the parallel resonant circuit RLC. The direct current measuring signal taken from the resistor Ro is amplified by the amplifier Ko. The alternating current measuring signal taken from the resonant circuit RLC is amplified by the amplifier Kz, AC coupled with this circuit via the coupling capacitors Cs. A phase-sensitive detector DET controlled by the external clock signal CLK is located at the output of the amplifier Kz. The alternating voltage, common to all branches connected in parallel, reaches the voltage measurement circuitry UPN where it is amplified by the amplifier KUz, AC coupled via a coupling capacitor CUs with the input measuring signal. At the output of this amplifier there is the phase-sensitive detector DETU, controlled by the same clock signal CLK as used for controlling the detectors DET. The arrangement of branches connected in parallel is excited by the power amplifier WM with the current input function lw which is AC coupled with the excited system via the coupling capacitor CWs. All measuring signals, that is the signals of the alternating voltage Uz, the alternating currents lz-1 to lz-n and the direct currents lo-1 to lo-n, are fed to the inputs of analog to digital converters of the microprocessor control system uP. The control system uP generates the pulse wodth modulated signal PWM, which is then transformed by power amplifier WM into the current sine lw. The control system uP generates also the clock waveform CLK to control the phase-sensitive detectors DET and DETU. The clock signal CLK is synchronous with the sine waveform that modulates the PWM signal. The clock signal CLK has the pulse duty ratio of 0.5 and can its phase be step-changed in respect to the modulating sine. Proper operation of the system operation requires that the phase shift between the clock signal CLK and the modulating sine is arbitrary but kept constant with an option to step-change this shift by 90° back and forth. The load OBC which is usually connected in parallel to the bank of batteries, conducts a part of the excitation current lw, decreasing the signal Uz only, and does not affect the ratio of the current lz in individual branches. Having measured the alternating voltage and the alternating currents in every branch for two values of the phase shift of the clock signal CLK, the microprocessor system uP determines the real and imaginary components of the impedance of each branch. The real component is the sought resistance of the battery circuit.

Fig. 2 shows the system for measuring the resistance of battery circuits connected in parallel in an embodiment using the switch MUX that enables using the single current measurement system UPP comprising the loads of the current transformer Ro for direct current, the loads RLC of the current transformer for alternating current, the amplifier Ko of the direct current signal and the amplifier Kz of the alternating current signal, AC coupled via the coupling capacitor Cs, as well as the phase-sensitive detector DET.

In the disclosed embodiment the microprocessor controller uP sequentially controls the switch MUX by means of the signal SW, measuring the direct current lo and the alternating current lz separately in each branch.

## Claims

1. A system for measuring the resistance of battery circuits connected in parallel, comprising Hall effect current transformers which operate in a closed feedback loop, sinusoidal current generator, measuring amplifiers and a microprocessor system, **characterized in that** in each of the measured circuits there is a current transformer (**PP**) with a load in the form of a resistor (**Ro**) connected in series and a parallel resonant circuit (**RLC**), and the measuring signals taken from these loads are routed through amplifiers (**Kz**), whereas the voltage measuring signal is additionally passed through an amplifier (**KUz**), and the outputs of both of these amplifiers are outfitted with phase-sensitive detectors (**DET**) controlled by the clock signal **CLK**.

2. A system according to Claim 1, **characterized in that** both the voltage measuring signals amplified by the amplifier (**KUz**) and current measuring signals amplified by amplifiers (**Kz**) are passed through phase-sensitive detectors (**DET**) controlled by the common clock signal **CLK** switched by a microprocessor system to step-change its phase by 90° between measurements.

3. A system according to Claims 1 and 2, **characterized in that** on the basis of measurements of signals proportional to the common voltage of the circuits of the bank of batteries and measurements of signals proportional to the currents in each circuit branch with a string of batteries, said measurements made with the 90° change of the phase shift between measurements, the microprocessor system determines the active component of the circuits as the result of the measurement, that is the resistance, leaving out the pasive components, that is the inductance.
